# EUROPÄISCHE PATENTANMELDUNG

(11) **EP 4 844 429 A1**
(43) Veröffentlichungstag der Anmeldung: **25.11.2026**
(21) Anmeldenummer: 25178417.9
(22) Anmeldetag: 23.05.2025
(51) Int. Cl.: G01R 31/42

(54) **TESTANORDNUNG UND VERFAHREN ZUR EMULATION VON STRÖMEN EINES ELEKTROMOTORS**

(71) Anmelder: dSPACE SE & Co. KG, 33102 Paderborn (DE)
(72) Erfinder: Epping, Daniel, 33102 Paderborn (DE); Kemper, Philipp, 33102 Paderborn (DE)

(57) **Zusammenfassung**

Die Anmeldung betrifft eine Testanordnung (10) zur Emulation von Strömen (IU, IV, IW, IX, IY) eines Elektromotors (M) für ein Prüfen eines leistungselektronischen Steuergeräts (DUT), wobei das Steuergerät (DUT) über zumindest zwei Anschlusspfade (U, V, W, X, Y) an die Testanordnung (10) anschließbar ist und zur Ansteuerung des Elektromotors (M) über die Anschlusspfade (U, V, W, X, Y) eingerichtet ist, wobei die Testanordnung (10) zum Austausch von einem jeweiligen Strom (IU, IV, IW, IX, IY) über einen jeweiligen Anschlusspfad (U, V, W, X, Y) eingerichtet ist, wobei für die Anschlusspfade (U, V, W, X, Y) eine jeweilige Stromquelle (12-18) vorgesehen ist, welche in Abhängigkeit von einem jeweiligen Vorgabewert (12.S-20.S) den jeweiligen Strom (IU, IV, IW, IX, IY) ausgibt, wobei eine erste der jeweiligen Stromquellen (12, 18) den Vorgabewert (12.S, 18.S) erhält, dass eine Summe der Ströme in einander zugeordneten Anschlusspfaden (U, V, W, X, Y) Null ergibt.

Die Anmeldung betrifft weiter ein Verfahren zur Emulation von Strömen.

## Beschreibung

### Technisches Gebiet

Die Anmeldung betrifft eine Testanordnung und ein Verfahren zur Emulation von Strömen eines Elektromotors für ein Prüfen eines leistungselektronischen Steuergeräts.

### Hintergrund

In DE102022133309A1 wird eine Testanordnung und ein Verfahren zur Emulation der Phasenströme eines Elektromotors für ein Prüfen eines leistungselektronischen Steuergeräts beschrieben. Dabei wird ein Induktivitätsemulator vorgeschlagen, der den Elektromotor als eine elektrische Last für das Steuergerät mittels einer Leistungselektronikschaltung nachbildet und eine Prüfeinrichtung, die eingerichtet ist, in Abhängigkeit von einer Analyse einer Ausgangsspannung an einem Ausgang des Steuergeräts den Induktivitätsemulator in einen anderen Betriebsmodus zu schalten.

### Übersicht

Bei einer Testanordnung (Power- HIL) zur Emulation von Strömen eines Elektromotors für ein Prüfen eines leistungselektronischen Steuergeräts ist das Steuergerät über zumindest zwei Anschlusspfade an die Testanordnung anschließbar. Das Steuergerät ist zur Ansteuerung des Elektromotors über die Anschlusspfade eingerichtet, wobei die Testanordnung zum Austausch von einem jeweiligen Strom über einen jeweiligen Anschlusspfad eingerichtet ist, wobei für die jeweiligen Anschlusspfade eine jeweilige Stromquelle vorgesehen ist, welche in Abhängigkeit von einem jeweiligen Vorgabewert den jeweiligen Strom ausgibt, wobei eine erste der jeweiligen Stromquellen den Vorgabewert erhält, dass eine Summe der Ströme in einander zugeordneten Anschlusspfaden Null ergibt.

Eine solche Testanordnung zur Emulation von Strömen eines Elektromotors für ein Prüfen eines leistungselektronischen Steuergeräts kann auch als Emulator bezeichnet werden. Der Emulator emuliert für das Steuergerät den durch das Steuergerät angesteuerten Elektromotor mit seinen Strömen. Die Testanordnung wird auch als strombasierter Power-Hardware-in-the-Loop Simulator oder kurz Power-HIL bezeichnet. Auch die Bezeichnung Simulator ist gebräuchlich.

Weiterhin wird ein Verfahren zur Emulation von Strömen eines Elektromotors für ein Prüfen eines leistungselektronischen Steuergeräts vorgeschlagen. Das Steuergerät ist ausgebildet, den Elektromotor über zumindest zwei Anschlusspfade anzusteuern, wobei für die jeweiligen Anschlusspfade eine jeweilige Stromquelle vorgesehen ist, welche in Abhängigkeit von einem jeweiligen Vorgabewert einen jeweiligen Strom ausgibt, wobei eine erste der Stromquellen den Vorgabewert erhält, dass eine Summe der Ströme in einander zugeordneten Anschlusspfaden Null ergibt.

Die beschriebene Testanordnung und das beschriebene Verfahren haben den Vorteil, dass aktiv einer Stromdifferenz der emulierten Ströme zwischen den einander zugeordneten Anschlusspfaden entgegengewirkt wird.

Die Testanordnung kann dabei so ausgelegt werden, dass sich die emulierten Ströme in den einander zugeordneten Anschlusspfaden in der Summe aufheben und z. B. passive Maßnahmen wie stromkompensierte Drosseln entfallen können. Die Ströme in den einander zugeordneten Anschlusspfade bilden dabei ein Stromsystem, wie es z. B. im Elektromotor auftritt.

Die Stromsumme der emulierten Ströme in dem Stromsystem des Elektromotors kann aktiv zu Null geregelt werden. Dies kann durch das zu prüfende Steuergerät erfasst werden, welches als steuernde Einheit des Elektromotors die Ströme in den Anschlussleitungen erfasst und überwacht. Das Erfassen und Überwachen kann insbesondere auch das Erfassen und Überwachen der Summe der Ströme in den einander zugeordneten Anschlusspfaden umfassen. Ein Auslösen die Summe betreffender Überwachungsmechanismen im Steuergerät kann dadurch zuverlässig vermieden werden. Hierdurch lassen sich Belastungen von z. B. Gleichtaktdrosseln und anderen Filterkomponenten im Steuergerät vermeiden, insbesondere wird vermieden, dass diese geschädigt werden.

Die Testanordnung emuliert den Elektromotor für das Steuergerät über die zumindest zwei Anschlusspfade, an die das Steuergerät angeschlossen ist und über die die Testanordnung jeweilige Ströme ausgibt. Für diese Stromerzeugung wird eine jeweilige Stromquelle für einen jeweiligen Anschlusspfad verwendet. Diese Stromquellen geben in Abhängigkeit von einem jeweiligen Vorgabewert den jeweiligen Strom aus. Eine der Stromquellen erhält den Vorgabewert, dass eine Summe der Ströme in einander zugeordneten Anschlusspfaden Null ergibt.

Die Testanordnung weist einen leistungselektronischen Teil auf, der die Stromquellen aufweist und der die Ströme gemäß des jeweiligen Vorgabewertes bereitstellt. Ein Vorgabewert betrifft wie beschrieben die Summe der Ströme in einander zugeordneten Anschlusspfaden. Weitere Vorgabewerte können z. B. durch ein Modell berechnet werden. Solche Stromquellen können z. B. durch leistungselektronische Bauteile, wie Stromreglerbausteine, realisiert werden. Diese Stromreglerbausteine werden üblicherweise durch Zusammenschaltung von Leistungsendstufen realisiert. Diese bestehen üblicherweise aus Leistungs-MOSFET-Schaltern oder IGBT-Schaltern in Kombination mit Leistungsdioden.

Mit der Emulation von Strömen des Elektromotors ist gemeint, dass die Testanordnung solche Ströme ausgibt, die ein Elektromotor in Reaktion auf die Ansteuerung des Steuergeräts ausgeben würde. Die Ansteuerung des Steuergeräts kann bspw. durch das Anlegen einer jeweiligen Spannung an die jeweiligen Anschlusspfade erfolgen. Der Elektromotor kann vorliegend ein Synchron-Elektromotor mit Permanentmagneten oder mit Fremderregung, also mit durch einen Erregerstrom erzeugten magnetischen Feldern im Rotor, sein. Andere Formen von Motoren die abgebildet werden können sind Asynchronmaschinen, Gleichstrommaschinen, Synchronreluktanzmaschinen und geschaltete Synchronreluktanzmaschinen..

Das leistungselektronische Steuergerät, das vorliegend getestet werden soll, weist einen leistungselektronischen Teil für die Ansteuerung des Elektromotors auf. Die Ansteuerung kann insbesondere ein Anlegen einer Ansteuerspannung an den jeweiligen Anschlusspfade umfassen.

Für die Ausgabe der Ströme auf dem jeweiligen Anschlusspfad ist eine jeweilige Stromquelle in dem jeweiligen Anschlusspfad vorgesehen. Die jeweilige Stromquelle erzeugt den jeweiligen Strom gemäß des jeweiligen Vorgabewertes und gibt den jeweiligen Strom aus. Die über die jeweiligen Anschlusspfade ausgetauschten Ströme entsprechen dabei den jeweiligen durch die Stromquellen erzeugten Strömen. Die über die jeweiligen Anschlusspfade ausgetauschten Ströme emulieren die Motorströme.

Mit der Vorgabe des Vorgabewertes Null für die Summe der Ströme in den einander zugeordneten Anschlusspfaden für den ersten Stromregler in dem ersten Anschlusspfad kann erreicht werden, dass diese Stromquelle einen Strom bereitstellt, der die Summe der Ströme der anderen zugeordneten Anschlusspfade zu Null kompensiert.

Bei der Testanordnung kann es sich um eine Einrichtung handeln, die dazu gedacht ist, Steuergeräte insbesondere leistungselektronische Steuergeräte auf ihre Funktion hin zu prüfen. Um das zu erreichen, wird dem Steuergerät über die Anschlusspfade durch die Testanordnung ein Elektromotor durch seine Ströme emuliert, sodass es möglich ist, das Steuergerät in verschiedenen Situationen zu prüfen, ohne einen tatsächlichen Elektromotor mit dem Steuergerät verbinden zu müssen. Dies ist kostengünstiger, variabler und effizienter, als einen Elektromotor tatsächlich anschließen zu müssen.

Mit der Emulation der Ströme ist gemeint, dass solche Ströme zwischen der Testanordnung und dem Steuergerät ausgetauscht werden, die zur Ansteuerung durch das Steuergerät passen. D. h. die Testanordnung gibt die Ströme aus, die ein Elektromotor in dem jeweiligen Betriebszustand ausgeben würde. Die Testanordnung kann auch als Emulator bezeichnet werden. Damit kann das leistungselektronische Steuergerät zur Ansteuerung des Elektromotors geprüft werden.

Solche leistungselektronischen Steuergeräte werden beispielsweise in Elektrofahrzeugen eingesetzt. Eine Kernkomponente solcher Steuergeräte ist eine Brückenschaltungen mit Halbleiterschaltern, die beispielsweise Leistungstransistoren sein können. Die Brückenschaltung kann dazu eingesetzt werden, Gleichspannug in Wechselspannung oder umgekehrt zu wandeln. Es sind auch Brückenschaltungen bekannt, die Gleichstrom in Wechselstrom und umgekehrt wandeln können. Die Brückenschaltung kann z. B. als Leistungswandler bezeichnet werden und - je nach Richtung der Leistungswandlung - als Wechselrichter oder Gleichrichter bezeichnet werden.

Bei dem leistungselektronischen Steuergerät handelt es sich beispielsweise um ein Steuergerät, das die Gleichspannung von der Fahrzeug-Batterie in eine Wechselspannung wandeln kann. Dazu weist das Steuergerät zumindest eine Brückenschaltung, z. B. einen Wechselrichter, auf, die üblicherweise mit Pulsweitenmodulation angesteuert wird. Das leistungselektronische Steuergerät kann auch einen Gleichsspannungs-/Gleichspannungs-Wandler, z. B. für die für die Ansteuerung eines Gleichstromelektromotors, aufweisen.

Das Steuergerät verfügt über einen Prozessor und Speicher zur Ausführung von weiteren Funktionen wie Selbsttests oder auch Prüffunktionen für den Elektromotor oder die angeschlossenen Geräte. Der Prozessor kann z. B. als Mikrocontroller ausgebildet sein, der die Funktionen des Steuergeräts ausführt. Die Kommunikation mit den weiteren angeschlossenen Geräten ist beispielsweise über eine Kommunikationsschnittstelle, beispielsweise über eine CAN-Bus, möglich. Daher kann das Steuergerät neben dem Wechselrichter, Prozessor, Speicher auch eine Kommunikationsschnittstelle aufweisen.

In einer Ausführungsform hängt der jeweilige Vorgabewert für die weiteren Stromquellen in den einander zugeordneten Anschlusspfaden von einer jeweiligen Spannung ab, die an dem jeweiligen Anschlusspfad anliegt. Zur Ansteuerung des Elektromotors legt das Steuergerät die Spannung an dem jeweiligen Anschlusspfad an. Der resultierende Strom in dem jeweiligen Anschlusspfade wird dann durch das Steuergerät ausgewertet und für die Regelung verwendet. Durch die Emulation der Ströme in den Anschlusspfaden kann das Steuergerät dann getestet werden.

Mit einander zugeordneten Anschlusspfaden ist gemeint, dass die Anschlusspfade zusammen zu einer Funktion gehören, bei der die Summe der über die Anschlusspfade ausgetauschten Ströme in der Realität, die emuliert werden soll, Null ergibt.

In einer Ausführungsform weist die Testanordnung eine Recheneinheit auf, die eingerichtet ist, den jeweiligen Vorgabewert für die weiteren Stromquellen in Abhängigkeit von der jeweiligen Spannung, die an dem jeweiligen Anschlusspfad anliegt, zu ermitteln. Damit bestimmt die Recheneinheit anhand der Ansteuerung den jeweiligen Vorgabewert für die weiteren Stromquellen in Abhängigkeit von der jeweiligen Spannung. Die Recheneinheit bestimmt in dieser Ausführungsform die Vorgabewerte für die jeweiligen Stromquellen und gibt sie an die Stromquellen aus. So kann die Testanordnung auf die Ansteuerung des Elektromotors durch das Steuergerät reagieren.

In einer Ausführungsform weist eine jeweilige Stromquelle einen jeweiligen Stromregler auf, welcher den jeweiligen Strom in Abhängigkeit von dem Vorgabewert und von einem jeweiligen Istwert regelt. Der Stromregler der Stromquelle ermittelt einen Istwert. Daraus bestimmt die Ansteuerung des Reglers einen entsprechenden Strom für die Ausgabe auf den jeweiligen Anschlusspfad. Der Stromregler empfängt sowohl den Istwert als auch den Vorgabewert. Entsprechend einer Differenz zwischen dem Istwert und dem Vorgabewert steuert der Stromregler nach. Die Stromquellen mit ihren Reglern können beispielsweise über die Recheneinheit angesteuert werden und aus einem Gleichspannungszwischenkreis mit elektrischer Energie gespeist werden. Optional kann die Testanordnung die Batterie aufweisen.

In einer Ausführungsform umfasst der Istwert für die erste Stromquelle den Istwert der Summe der Ströme der einander zugeordneten Anschlusspfade und/oder der Istwert für die weiteren Stromquellen umfasst den Istwert des Stroms auf dem jeweiligen Anschlusspfad. Unter Verwendung dieser Informationen zu den Istwerten kann der Gesamtstrom zu Null geregelt werden. Insbesondere kann die Summe der Ströme als Istwert für die erste Stromquelle als Summe aus den Strömen der Anschlusspfade ermittelt werden oder es kann die Summe der Ströme der Anschlusspfade an einer Verbindungsstelle der Anschlusspfade zusammen ermittelt werden. Es sind auch Mischformen möglich, um die Summe der Ströme der Anschlusspfade zu ermitteln.

In einer Ausführungsform ist für die Ermittlung der jeweiligen Ströme der jeweiligen Anschlusspfade eine jeweilige Einzel-Stromermittlungseinrichtung vorgesehen. Die Einzel-Stromermittlungseinrichtung ist dann in den jeweiligen Anschlusspfaden angeordnet. Der ermittelte Strom dient dann jeweils als Istwert für den zugehörigen Stromregler und optional als Komponente des Summenstroms. Optional kann jeder derAnschlusspfade, auch der erste Anschlusspfad, der die erste Stromquelle aufweist, eine solche Einzel-Stromermittlungseinrichtung aufweisen.

In einer Ausführungsform ist für die Ermittlung der Summe der Ströme der einander zugeordneten Anschlusspfade eine Gesamt-Stromermittlungseinrichtung vorgesehen. Die Gesamt-Stromermittlungseinrichtung kann insbesondere auch als Summenstrommesser ausgebildet sein, der die Summe der Ströme über die jeweils einander zugeordneten Anschlusspfade erfasst. Damit kann dann der Summenstrom über die Leiter der Anschlusspfade effizient und zuverlässig ermittelt werden.

Die Einzel-Stromermittlungseinrichtung aber auch die Gesamt-Stromermittlungseinrichtung weisen daher die entsprechenden Mittel auf, um den Gesamtstrom zu bestimmen.

In einer Ausführungsform der Anmeldung ist die Gesamt-Stromermittlungseinrichtung und/oder die jeweilige Einzel-Stromermittlungseinrichtung als Induktivwandler oder als Halleffektsensor ausgebildet. Mit dem Induktivwandler oder auch dem Halleffektsensor können die Ströme sicher und effizient sowie galvanisch getrennt ermittelt werden.

Alternativ oder zusätzlich ist auch die Messung einer Spannung an einem bekannten ohmschen Widerstand und die Umrechnung in einen Strom möglich. Andere Technologien zur Stromermittlung sind ebenfalls möglich.

Die Testanordnung kann eingerichtet sein, die Summe der Ströme über die einander zugeordneten Anschlusspfade unter Verwendung der jeweiligen Ströme der Anschlusspfade zu ermitteln. Die jeweiligen Ströme können dabei zur Summe addiert werden.

Die Addition ist im analogen Bereich durch die Durchführung der Addition von analogen Signalen möglich. Zum Beispiel können analoge Ausgabewerte der jeweiligen Einzel-Stromermittlungseinrichtungen analog addiert werden.

Die Addition ist auch im digitalen Bereich durch die Durchführung der Addition von digitalen Signale möglich. Zum Beispiel können mittels Analog-Digitalwandlung digitalisierte Ausgabewerte der jeweiligen Einzel-Stromermittlungseinrichtungen digital addiert werden. Dies kann beispielsweise auch über Digitalausgänge von jeweiligen Bauelementen, wie es beispielsweise Stromregler sind, realisiert werden. Von diesen Digitalausgängen kann z. B. jeweils der Einzelstrom des jeweiligen Stromreglers abgerufen werden.

Es sind auch Mischformen zur Ermittlung der Summe der Ströme mit Wandlungen von analog zu digital und umgekehrt möglich.

In einer Ausführungsform der Testanordnung sind die einander zugeordneten Anschlusspfade für Phasenströme des emulierten Elektromotors vorgesehen. Die Phasenströme eines realen Elektromotors ergeben in der Summe Null. Diese Eigenschaft wird durch die emulierten Ströme nachgebildet.

In einer Ausführungsform der Testanordnung sind drei oder mehr einander zugeordnete Anschlusspfade für drei oder mehr jeweilige Phasenströme des emulierten Elektromotors vorgesehen.

In einer Ausführungsform der Testanordnung sind zwei einander zugeordnete Anschlusspfade für einen Erregerstrom des Elektromotors vorgesehen. Damit können dann zuverlässig auch Erregerströme des Elektromotors zum Testen des Steuergeräts emuliert werden. Die Anschlusspfade sind dann insbesondere einem emulierten Erregerstromkreis für einen fremderregten Elektromotor zugeordnet.

Durch das Steuergerät können sowohl Phasenströme als auch Erregerströme geregelt werden. Dabei werden die Phasenströme des Elektromotors als einander zugeordnet betrachtet und die Anschlusspfade, in denen ein jeweiliger Erregerstrom fließt, werden als einander zugeordnet betrachtet.

Die Testanordnung und das Verfahren sind auch für weitere Zuordnungen der Anschlusspfade und der einander zugeordneten Anschlusspfade realisierbar. Gemein ist den verschiedenen möglichen Bedeutungen von einander zugeordneten Anschlusspfaden, dass die Summe der darüber ausgetauschten Ströme in der Realität, die emuliert werden soll, Null ergibt.

Mittels der Testanordnung kann beispielsweise ein Wechselstrom-Elektromotor emuliert werden. Die Testanordnung emuliert dann die Phasenströme des Elektromotors. Dabei hat solch ein Wechselstrom-Elektromotor beispielsweise drei oder sechs Phasen. Es sind jedoch auch mehr oder weniger Phasen möglich. Je nach Motortyp kann die Anzahl der Phasen variieren, es sind zum Beispiel auch zwei, fünf, sieben etc. möglich.

Auch Gleichstrommotoren können durch die Testanordnung emuliert werden und werden durch eine zweiphasige Halbbrücken-Topologie, die sich im Steuergerät befindet, angesteuert. Für Gleichstrommotoren kann die Testanordnung z. B. den Erregerstrom emulieren, der das magnetische Feld erzeugt. Es ist ebenfalls möglich, mit der Testanordnung die Phasen eines Gleichstromelektromotors nachzubilden.

### Figurenliste

Ausführungsbeispiele der Erfindung sind in den Figuren dargestellt und werden in der nachfolgenden Beschreibung näher erläutert.

Es zeigen
- **Figur 1**: ein Blockschaltbild einer Ausführungsform der Testeinrichtung mit angeschlossenem Steuergerät,
- **Figur 2**: ein Ersatzschaltbild einer Ansteuerung von Phasenströmen im Steuergerät,
- **Figur 3**: ein Ersatzschaltbild einer Ansteuerung von Erregerströmen im Steuergerät,
- **Figur 4**: schematisch eine Ausführungsform der Testanordnung zur Emulation von Phasenströmen und
- **Figur 5**: schematisch eine Ausführungsform der Testanordnung zur Emulation von Erregerströmen.

Es werden in den Figuren die gleichen Bezugszeichen für gleiche oder ähnliche Elemente verwendet. Die Darstellungen in den Figuren können nicht maßstäblich sein.

### Figurenbeschreibung

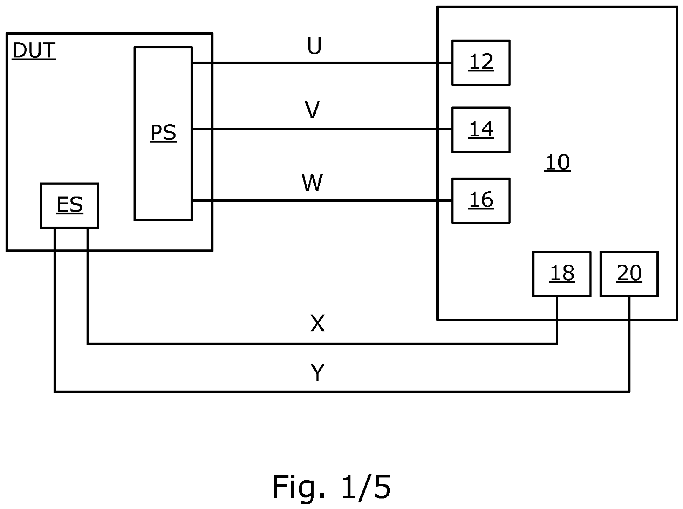

Figur 1 zeigt schematisch in einem Blockschaltbild eine Ausführungsform einer Testanordnung 10, die über mehrere Anschlusspfade U, V, W, X und Y mit einem Steuergerät DUT verbunden ist. Die Aufgabe der Testanordnung 10 ist es, das Steuergerät DUT als Device-Under-Test in seiner Funktionalität zu prüfen.

Das Steuergerät DUT weist eine Ansteuerung Phasenstrom PS auf, an die die Anschlusspfade U, V, W angeschlossen sind. Die Ansteuerung Phasenstrom PS ist eine leistungselektronische Schaltung, die jeweilige Spannungen über die jeweiligen Anschlusspfade U, V, W ausgibt und damit den durch die Testanordnung 10 emulierten Elektromotor ansteuert. Die Ansteuerung Phasenstrom PS kann z. B. einen Wechselrichter umfassen.

Auf Seiten der Testanordnung 10 sind an den Anschlusspfaden U, V, W jeweils die Stromquellen 12, 14 und 16 angeschlossen, d. h. an den Anschlusspfad U ist die Stromquelle 12, an den Anschlusspfad V die Stromquelle 14 und an den Anschlusspfad W die Stromquelle 16 angeschlossen. Die Stromquellen 12, 14 und 16 prägen jeweilige Ströme IU, IV, IW auf die jeweiligen Anschlusspfade U, V, W auf. Die Ströme IU, IV, IW werden entsprechend der Ausgangsspannungen der Ansteuerung Phasenstrom PS ausgegeben.

Alternativ zu den drei Phasenströmen gemäß Figur 1 können auch fünf oder sechs oder mehr Phasenströme vorliegen. Es kann auch vorgesehen sein, das beispielsweise nur 2 Phasenströme von dreien emuliert werden.

Das Steuergerät DUT weist weiterhin eine Ansteuerung Erregerstrom ES auf, an die die Anschlusspfade X und Y angeschlossen sind. Auf Seiten der Testanordnung 10 sind an den Anschlusspfad X eine Stromquelle 18 und an den Anschlusspfad Y eine Stromquelle 20 angeschlossen. Die Stromquellen 18, 20 prägen jeweilige Ströme IX, IY auf die jeweiligen Anschlusspfade X, Y auf. Die Ströme IX, IY werden entsprechend der Ausgangsspannungen der Ansteuerung Erregerstrom ES ausgegeben. Der Erregerstrom IX, IY weist Hin- und Rückstrom über die Pfade X, Y auf und dient zu einer Fremderregung im tatsächlichen Elektromotor, der beispielsweise keine Permanentmagnete zur Selbsterregung aufweist. Auch die Ansteuerung Erregerstrom PS ist eine leistungselektronische Schaltung mit Leistungsschaltern.

Die Stromquellen 12, 14, 16 sowie die Stromquellen 18 und 20 weisen Stromregler auf, mittels derer der durch die Stromquellen 12-20 abgegebene Strom geregelt werden kann.

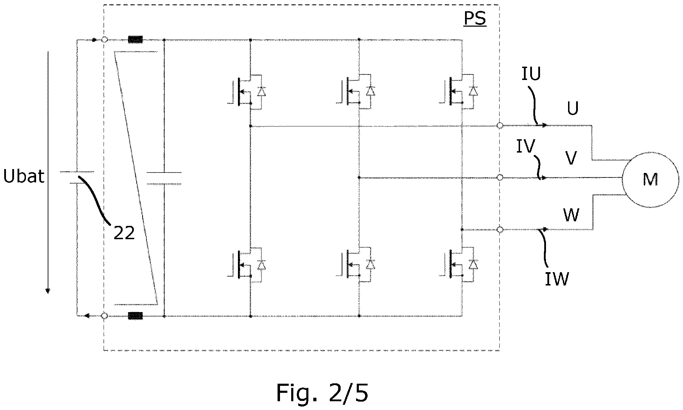

Figur 2 zeigt in einem Ersatzschaltbild eine mögliche leistungselektronische Schaltungsanordnung der Ansteuerung Phasenstrom PS, an die der zu emulierende Elektromotor M angeschlossen ist. Der zu emulierende Elektromotor M ist über die Anschlusspfade U, V, W an die Ansteuerung Phasenstrom PS des Steuergeräts DUT angeschlossen. In Figur 2 sind auch die Phasenströme IU, IV, IW dargestellt, die der Elektromotor M mit der Ansteuerung Phasenstrom PS austauscht. Diese Phasenströme IU, IV, IW können durch die Testanordnung 10 emuliert werden.

Die Ansteuerung Phasenstrom PS weist drei parallel geschaltete Brückenzweige mit jeweils zwei Leistungsschaltern auf, die als Transistoren ausgebildet sind. Beispielsweise können als Transistortypen MOSFETs verwendet werden. Die Leistungsschalter werden über ihre jeweiligen Gates z. B. durch einen Pulsweitenmodulator angesteuert. Damit kann aus der Batterie 22 mit der Batteriespannung Ubat, die eine Gleichspannung ist, eine dreiphasige Wechselspannung erzeugt werden.

Über einen Abgriff in der Mitte eines jeweiligen Zweiges zwischen den jeweiligen Leistungsschaltern werden die drei jeweiligen Anschlusspfade U, V, W seitens der Ansteuerung Phasenstrom PS zum Motor M geführt. Die Anschlusspfade U, V, W sind für die jeweiligen Phasenströme IU, IV, IW und Phasenspannungen UU, UV, UW des Elektromotors M vorgesehen. Über die Anschlusspfade U, V, W werden die Phasenspannungen UU, UV, UW an den Motor M ausgegeben, was in den Phasenströmen IU IV und IW resultiert, die in den Wicklungen des Elektromotors M fließen.

Zu den drei parallelen Zweigen mit den jeweils in Reihe geschalteten Leistungsschaltern ist parallel ein Kondensator und eine Schaltung von Induktivitäten angeschlossen, wobei an diese Schaltung, die Batteriespannung Ubat einer Batterie 22 anliegt. Die Batterie 22 kann beispielsweise auch über eine emulierte Batterie 22 sein.

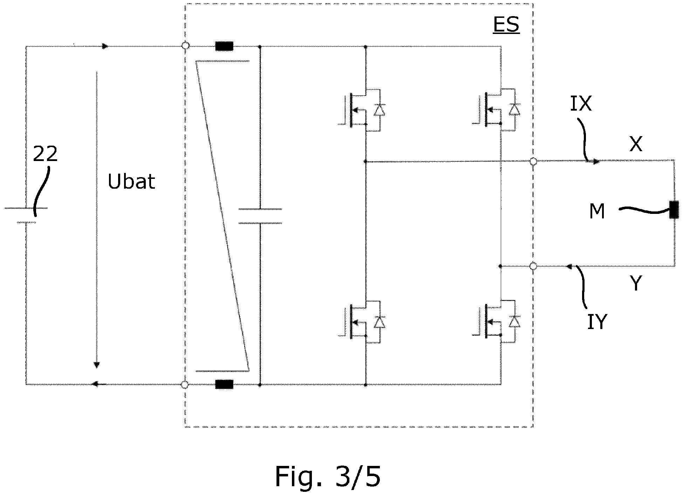

Figur 3 zeigt in einem Ersatzschaltbild eine mögliche leistungselektronische Schaltungsanordnung der Ansteuerung Erregerstrom ES, an die der zu emulierende Elektromotor M angeschlossen ist. Der Aufbau ist sehr ähnlich zu Figur 2. In Figur 3 sind zwei Zweige mit einer Reihenschaltung von zwei Transistoren parallel geschaltet. Ein Zweig speist den Anschlusspfad X, über den der Strom IX fließt. Der andere Zweig speist den Anschlusspfad Y, über den der Strom IY fließt.

Über einen Abgriff in der Mitte eines jeweiligen Zweiges zwischen den jeweiligen Leistungsschaltern werden die zwei jeweiligen Anschlusspfade X, Y seitens der Ansteuerung Erregerstrom ES zum Motor M geführt. Die Anschlusspfade X, Y sind für die jeweiligen Phasenströme IX, IY und Phasenspannungen UX, UY des Elektromotors M vorgesehen. Über die Anschlusspfade X, Y wird die Erregerspannung UX, UY an den Motor M ausgegeben, was in dem Hinstrom IX und Rückstrom IY des Erregerstroms resultiert.

Die übrigen Komponenten sind entsprechend der Darstellung in Figur 2 ausgebildet.

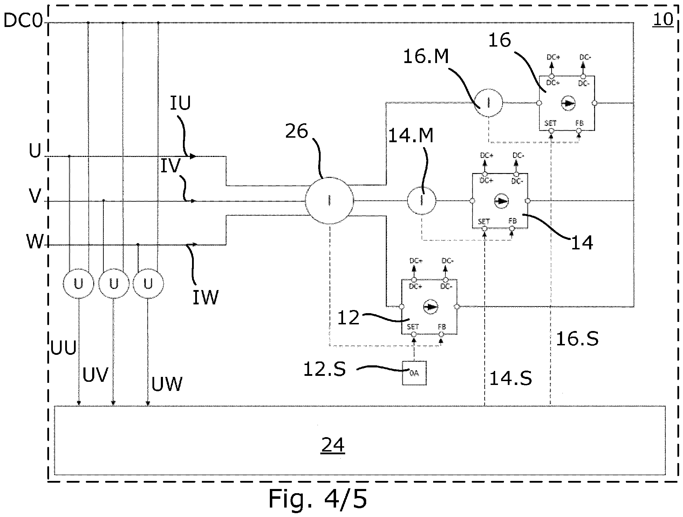

In Figur 4 ist schematisch in einem Schaltbild eine Ausführungsform der Testanordnung 10 zur Emulation von Phasenströmen dargestellt. Für die drei jeweiligen Anschlusspfade U, V, W sind jeweilige Stromquellen 12, 14 und 16 vorgesehen, die die jeweiligen Phasenströme IU, IV, IW erzeugen.

Für den Pfad U ist die Stromquelle 16 vorgesehen, die einen Stromregler aufweist und von einer Recheneinheit 24 einen Vorgabewert 16.S bekommt. Auf diesen Vorgabewert soll der Regler der Stromquelle 16 den Ausgangsstrom IU regeln.

Für den Pfad V ist die Stromquelle 14 vorgesehen, die einen Stromregler aufweist und von der Recheneinheit 24 den Vorgabewert 16.S bekommt. Auf diesen Vorgabewert soll der Regler der Stromquelle 14 den Ausgangsstrom IV regeln.

Vorgabewerte 16.S, 14.S werden von der Recheneinheit 24 ermittelt. Beispielsweise kann auf der Recheneinheit ein Simulationsmodell ablaufen, welches aus den Phasenspannungen UU, UV, UW jeweilige Soll-Phasenströme ermittelt. Das Simulationsmodell kann insbesondere in Software implementiert sein und die Vorgänge in dem Elektromotor M simulationstechnisch nachbilden. Die durch die Recheneinheit ermittelten Soll-Phasenströme für die Anschlusspfade V, W werden als die Vorgabewerte 16.S, 14.S an die jeweiligen Stromquellen 16, 14 ausgegeben.

Die Spannung UU wird zwischen dem Anschlusspfad U und Masse DC0 durch ein Spannungsmessgerät ermittelt. Die Spannung UV wird zwischen dem Anschlusspfad V und Masse DC0 durch ein weiteres Spannungsmessgerät ermittelt. Die Spannung UW wird zwischen dem Anschlusspfad W und Masse DC0 durch ein weiteres Spannungsmessgerät ermittelt.

Die Stromquelle 16 gibt den Strom IU aus. Über die Spannungsversorgungseingänge DC+ und DC- wird die Stromquelle 16 mit entsprechender elektrischer Energie versorgt. Über den Eingang SET erhält die Stromquelle 16 den Vorgabewert 16.S von der Recheneinheit 24. Über den Eingang FB erhält die Stromquelle 16 von der Einzel-Stromermittlungseinrichtung 16.M eine Messung des Ist-Stroms IU. Entsprechend einer möglichen Differenz zwischen dem Vorgabewert 16.S und dem Messwert des Ist-Stroms IU über den Eingang FB regelt der Regler der Stromquelle 16 den Strom IU nach.

Entsprechendes gilt für den Anschlusspfad V. Die Stromquelle 14 gibt den Strom IV aus. Über die Spannungsversorgungseingänge DC+ und DC- wird d die Stromquelle 14 mit entsprechender elektrischer Energie versorgt. Über den Eingang SET erhält der Regler der Stromquelle 14 den Vorgabewert 14.S von der Recheneinheit 24. Über den Eingang FB erhält die Stromquelle 14 von der Einzel-Stromermittlungseinrichtung 14.M eine Messung des Ist-Stroms IV. Entsprechend einer möglichen Differenz zwischen dem Vorgabewert 14.S und dem Messwert des Ist-Stroms IV über den Eingang FB regelt die Stromquelle 14 den Strom IV nach.

Der Regler der Stromquelle 12 im Anschlusspfad W erhält den Vorgabewert 12.S als 0A über seine Schnittstelle SET. Über seinen Eingang FB ist die Stromquelle 12 mit einer Gesamt-Stromermittlungseinrichtung 26 verbunden, die einen Gesamtstrom aller drei Anschlusspfade U, V, W zusammenführt. Damit ist es dem Regler der Stromquelle 12 möglich, präzise einen Strom IW an seinem Ausgang einzustellen, der den Gesamtstrom, der von der Gesamt-Stromermittlungseinrichtung 26 ermittelt wurde, kompensiert, also auf Null regelt.

Über DC0 sind die Stromquellen 12, 14, 16 mit dem Zwischenkreismittelpunkt der Einspeisung verbunden und über die Schnittstellen DC+ und DC- mit einer Versorgungsgleichspannung.

Durch die Regelcharakteristik der Stromquelle 12 ist es möglich, die Phasenströme U, V, W des zu emulierenden Elektromotors so auszugeben, dass sie in der Summe, , Null ergeben.

Das in der Recheneinheit 24 ablaufende Simulationsmodell berechnet dabei auch einen Soll-Phasenstrom für den Anschlusspfad W.

Bei der individuellen Regelung der Ströme zusammen mit der Anforderung der Null-Summe, ergibt sich ein überbestimmtes System. Es kann dabei z. B. auf Grund von Modell- und Regelabweichungen, Sollwertverzögerung als auch auf Grund von Systemgegebenheiten dazu kommen, dass die Stromsumme bei der individuellen Regelung durch die Testumgebung 10 mit den Sollwerten aus dem Modell der Recheneinheit nicht immer genau zu Null geregelt werden kann. Im System aus den Stromquellen 12, 14, 16 können so Abweichungen und Instabilitäten entstehen, welche durch die beschriebene Testumgebung und das beschriebene Verfahren vermieden werden können.

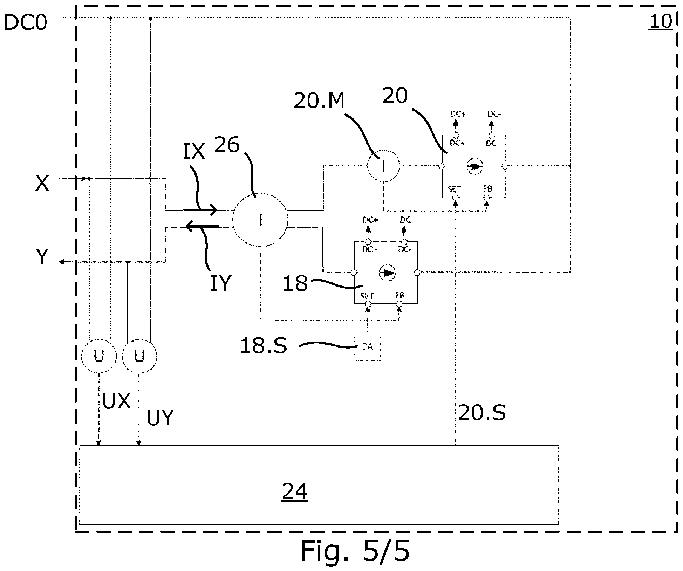

In Figur 5 ist schematisch in einem Schaltbild eine Ausführungsform der Testanordnung 10 zur Emulation von Erregerströmen dargestellt.

Für die zwei jeweiligen Anschlusspfade X, Y sind jeweilige Stromquellen 18, 20 vorgesehen, die den jeweiligen Hinstrom IX und Rückstrom IY des Erregerstroms erzeugen.

Vorgabewerte 18.S, 20.S werden von der Recheneinheit 24 ermittelt. Beispielsweise kann auf der Recheneinheit ein Simulationsmodell ablaufen, welches aus den Erregerspannungen UX, UY jeweilige Soll-Ströme ermittelt. Das Simulationsmodell kann insbesondere in Software implementiert sein und die Vorgänge in dem Erregerkreis des Elektromotors M simulationstechnisch nachbilden. Der durch die Recheneinheit ermittelte Soll-Strom für den Anschlusspfad X wird als der Vorgabewert 20.S an den Regler der Stromquelle 20 ausgegeben.

Die Spannung UX wird zwischen dem Anschlusspfad X und Masse DC0 durch ein Spannungsmessgerät ermittelt. Die Spannung UY wird zwischen dem Anschlusspfad Y und Masse DC0 durch ein weiteres Spannungsmessgerät ermittelt.

Die Stromquelle 20 gibt den Strom IX aus. Über die Spannungsversorgungseingänge DC+ und DC- wird die Stromquelle 20 mit entsprechender elektrischer Energie versorgt. Über den Eingang SET erhält der Regler der Stromquelle 20 den Vorgabewert 20.S von der Recheneinheit 24. Über den Eingang FB erhält der Regler der Stromquelle 20 von der Einzel-Stromermittlungseinrichtung 20.M eine Messung des Ist-Stroms IX. In Abhängigkeit von seinem Vorgabewert 20.S und dem gemessenen Ist-Stromwert für IX stellt der Regler der Stromquelle 20 seinen Ausgangsstrom IX neu ein, um den Vorgabewert 20.S zu erreichen.

Über Schnittstellen DC+ und DC- wird die Stromquelle 20 aus einer Gleichspannungsversorgung mit Energie versorgt. Über die Schnittstelle DC0 ist die Stromquelle 20 mit Zwischenkreismittelpunkt der Einspeisung DC0 verbunden.

Im Anschlusspfad Y ist die Stromquelle 18 vorgesehen, die einen Stromregler aufweist, welcher den Vorgabewert 18.S von 0A von der Recheneinheit 24 über seine Schnittstelle SET erhält. Als Messwert erhält der Regler der Stromquelle 18 von der Gesamt-Stromermittlungseinrichtung 26 den Gesamtstrom der beiden Anschlusspfade X und Y über seine Schnittstelle FB. Da der Vorgabewert 18.S 0A ist, wird der Regler der Stromquelle 18 den Gesamtstrom, der von der Gesamt-Stromermittlungseinrichtung 26 ermittelt und übermittelt wird, über seinen Strom IY an seinem Ausgang kompensieren und damit den Gesamtstrom auf 0A korrigieren.

Über die Schnittstellen DC+ und DC- erhält die Stromquelle 18 Energie aus einer Gleichspannungsversorgung und über die Schnittstelle DC0 ist die Stromquelle 18 mit Masse DC0 verbunden.

### Bezugszeichenliste

- 10: Testanordnung
- 12-20: Stromquellen
- 22: Batterie
- 24: Recheneinheit
- 26: Gesamt-Stromermittlungseinrichtung
- 12.S - 20.S: Vorgabewerte
- 14.M, 16.M, 20.M: Einzel-Stromermittlungseinrichtung
- DUT: Steuergerät
- ES: Ansteuerung Erregerstrom
- PS: Ansteuerung Phasenstrom
- M: Elektromotor
- U, V, W: zugeordnete Anschlusspfade Phasenstrom
- X, Y: zugeordnete Anschlusspfade Erregerstrom
- Ubat: Batteriespannung
- IU, IV, IW: Phasenströme
- IX, IY: Erregerstrom
- UU, UV, UW: Phasenspannungen
- UX, UY: Erregerspannungen

## Patentansprüche

1. Testanordnung (10) zur Emulation von Strömen (IU, IV, IW, IX, IY) eines Elektromotors (M) für ein Prüfen eines leistungselektronischen Steuergeräts (DUT), wobei das Steuergerät (DUT) über zumindest zwei Anschlusspfade (U, V, W, X, Y) an die Testanordnung (10) anschließbar ist und zur Ansteuerung des Elektromotors (M) über die Anschlusspfade (U, V, W, X, Y) eingerichtet ist, wobei die Testanordnung (10) zum Austausch von einem jeweiligen Strom (IU, IV, IW, IX, IY) über einen jeweiligen Anschlusspfad (U, V, W, X, Y) eingerichtet ist, wobei für die Anschlusspfade (U, V, W, X, Y) eine jeweilige Stromquelle (12-18) vorgesehen ist, welche in Abhängigkeit von einem jeweiligen Vorgabewert (12.S-20.S) den jeweiligen Strom (IU, IV, IW, IX, IY) ausgibt, wobei eine erste der jeweiligen Stromquellen (12, 18) den Vorgabewert (12.S, 18.S) erhält, dass eine Summe der Ströme in einander zugeordneten Anschlusspfaden (U, V, W, X, Y) Null ergibt.

2. Testanordnung (10) nach Anspruch 1, wobei der jeweilige Vorgabewert (14.S, 16.S, 20.S) für die weiteren Stromquellen (14, 16, 20) in den einander zugeordneten Anschlusspfaden (U, V, X) von einer jeweiligen Spannung (UU, UV, UX) abhängt, die an dem jeweiligen Anschlusspfad (U, V, X) anliegt.

3. Testanordnung (10) nach Anspruch 1 oder 2, wobei die Testanordnung (10) eine Recheneinheit (24) aufweist, die eingerichtet ist, den jeweiligen Vorgabewert (14.S, 16.S, 20.S) für die weiteren Stromquellen (14, 16, 20) in Abhängigkeit von der jeweiligen Spannung (UU, UV, UX), die an dem jeweiligen Anschlusspfad (U, V, X) anliegt, zu ermitteln.

4. Testanordnung nach einem der vorhergehenden Ansprüche, wobei eine jeweilige Stromquelle (12-18) einen jeweiligen Stromregler aufweist, welcher den jeweiligen Strom (IU, IV, IW, IX, IY) in Abhängigkeit von einem jeweiligen Istwert ausgibt.

5. Testanordnung nach Anspruch 4, wobei der Istwert für die erste Stromquelle (14, 18) den Istwert der Summe der Ströme der einander zugeordneten Anschlusspfade (U, V, W, X, Y) umfasst und/oder wobei der Istwert für die weiteren Stromquellen (16, 18, 20) den Istwert des Stromes auf dem jeweiligen Anschlusspfad (U, V, X) umfasst.

6. Testanordnung (10) nach einem der vorhergehenden Ansprüche, wobei für die Ermittlung der jeweiligen Ströme der Anschlusspfade (U, V, X) eine jeweilige Einzel-Stromermittlungseinrichtung (14.M, 16.M, 20.M) vorgesehen ist.

7. Testanordnung (10) nach einem der vorhergehenden Ansprüche, wobei für die Ermittlung der Summe der Ströme der einander zugeordneten Anschlusspfade (U, V, W, X, Y) eine Gesamt-Stromermittlungseinrichtung (26) vorgesehen ist.

8. Testanordnung (10) nach Anspruch 6 oder 7, wobei die Gesamt-Stromermittlungseinrichtung (26) und/oder die jeweilige Einzel-Stromermittlungseinrichtung (14.M, 16.M, 20.M) als Induktivwandler oder als Hall-Effekt Sensor ausgebildet ist.

9. Testanordnung nach Anspruch 7 oder 8, wobei die Gesamt-Stromermittlungseinrichtung (26) als Summenstrommesser über die einander zugeordneten Anschlusspfade (U, V, W, X, Y) ausgebildet ist.

10. Testanordnung (10) nach einem der vorhergehenden Ansprüche, wobei die Testanordnung eingerichtet ist, die Summe der Ströme über die einander zugeordneten Anschlusspfade (U, V, W, X, Y) unter Verwendung der jeweiligen Ströme (IU, IV, IW, IX, IY) der Anschlusspfade (U, V, W, X, Y) zu ermitteln.

11. Testanordnung (10) nach Anspruch 10, wobei die Testanordnung eingerichtet ist, die jeweiligen Ströme (IU, IV, IW, IX, IY) der einander zugeordneten Anschlusspfade für die Ermittlung der Summe der Ströme über die Anschlusspfade (U, V, W, X, Y) analog zusammenzuführen.

12. Testanordnung (10) nach Anspruch 10, wobei die Testanordnung eingerichtet ist, die jeweiligen Ströme (IU, IV, IW, IX, IY) der Anschlusspfade (U, V, W, X, Y) für die Ermittlung der Summe der Ströme über die Anschlusspfade (U, V, W, X, Y) digital zusammenzuführen.

13. Testanordnung (10) nach einem der vorhergehenden Ansprüche, wobei einander zugeordnete Anschlusspfade (U, V, W) für Phasenströme (U, V, W) des Elektromotors (M) vorgesehen sind.

14. Testanordnung (10) nach Anspruch 13, wobei drei oder mehr einander zugeordnete Anschlusspfade (U, V, W) für drei oder mehr jeweilige Phasenströme (U, V, W) des Elektromotors (M) vorgesehen sind.

15. Testanordnung (10) nach einem der vorhergehenden Ansprüche, wobei zwei einander zugeordnete Anschlusspfade (X, Y) für einen Erregerstrom (IX, IY) des Elektromotors (M) vorgesehen sind.

16. Verfahren zur Emulation von Strömen (IU, IV, IW, IX, IY) eines Elektromotors (M) für ein Prüfen eines leistungselektronischen Steuergeräts (DUT), wobei das Steuergerät (DUT) ausgebildet ist, den Elektromotor (M) über zumindest zwei Anschlusspfade (U, V, W, X, Y) anzusteuern, wobei für die Anschlusspfade (U, V, W, X, Y) eine jeweilige Stromquelle (12-20) vorgesehen ist, welche in Abhängigkeit von einem jeweiligen Vorgabewert (12.S-20.S) einen jeweiligen Strom (IU, IV, IW, IX, IY) ausgibt, wobei eine erste der Stromquellen (12, 18) den Vorgabewert (12.S, 18.S) erhält, dass eine Summe der Ströme in einander zugeordneten Anschlusspfaden (U, V, W, X, Y) Null ergibt.
